(19) **Europäisches Patentamt**

**European Patent Office**

**Office européen des brevets**

(11) **EP 0 905 899 B1**

(12) **EUROPÄISCHE PATENTSCHRIFT**

(45) Veröffentlichungstag und Bekanntmachung des Hinweises auf die Patenterteilung:
**24.11.2004 Patentblatt 2004/48**

(51) Int Cl.$^7$: **H03K 17/082**

(21) Anmeldenummer: **98116624.2**

(22) Anmeldetag: **02.09.1998**

(54) **Leistungsschalter mit Überlastschutz**

Power switch with overload protection

Commutateur de puissance avec protection contre les surcharges

(84) Benannte Vertragsstaaten:
**DE FR GB IT**

(30) Priorität: **29.09.1997 DE 19742930**

(43) Veröffentlichungstag der Anmeldung:
**31.03.1999 Patentblatt 1999/13**

(73) Patentinhaber: **Infineon Technologies AG**
**81669 München (DE)**

(72) Erfinder: **Feldtkeller, Martin**
**81543 München (DE)**

(74) Vertreter: **Bickel, Michael et al**
**Westphal - Mussgnug & Partner**
**Patentanwälte**
**Mozartstrasse 8**
**80336 München (DE)**

(56) Entgegenhaltungen:
**EP-A- 0 373 694      WO-A-95/05032**
**DE-A- 3 936 544**

**Beschreibung**

Die Erfindung betrifft einen Leistungsschalter, der in einen zwischen Anschlüsse für eine Versorgungsspannung geschalteten Strompfad geschaltet ist und Schaltungsmittel für einen Überlastschutz aufweist.

Leistungsschalter sind in Reihe mit einer Last zwischen Anschlüsse für eine Versorgungsspannung geschaltet, um die Versorgungsspannung zeitweise an die Last anzulegen. Es ist erforderlich, daß die üblicherweise als Leistungstransistoren ausgeführten Schalter vor Überlastung geschützt sind, um eine Zerstörung aufgrund von übermäßiger Verlustwärme zu vermeiden. Kritisch ist besonders, wenn in der Last ein Kurzschluß auftritt und am Schalter nahezu die volle Versorgungsspannung anliegt.

In der DE 39 36 544 A1 sind Maßnahmen zum Kurzschlußschutz eines taktweise betriebenen Leistungsschalters beschrieben. Ein den Schalttransistor steuerndes Eingangssignal wird um eine konstante Verzögerungszeit verzögert. Das verzögerte Steuerungssignal gibt einen Schalter frei, der beim Auftreten einer durch den Lastkurzschluß bedingten Überspannung leitend gesteuert wird, um den Leistungstransistor dadurch abzuschalten. Zusätzlich wird der Leistungstransistor abgeschaltet, wenn eine Übertemperatur durch einen mit dem Leistungsschalter thermisch gekoppelten Temperatursensor festgestellt wird.

Die Aufgabe der Erfindung besteht darin, einen Leistungsschalter mit Überlastschutz anzugeben, der eine in allen Betriebsbedingungen sichere Abschaltung ermöglicht.

Erfindungsgemäß wird diese Aufgabe durch einen Leistungsschalter mit Überlastschutz nach den Merkmalen des Patentanspruchs 1 gelöst.

Die Erfindung ist besonders vorteilhaft für den Fall anwendbar, daß der Leistungsschalter und die Schaltungsmaßnahmen für den Überlastschutz auf getrennten, aber thermisch gekoppelten integrierten Schaltungen angeordnet sind. Durch das Zeitglied wird ein sicheres Abschalten bei Lastkurzschluß, wenn am Leistungsschalter nahezu die volle Betriebsspannung anliegt, ermöglicht. Der Überlastschutz ist darüber hinaus besonders geeignet für periodisch geschaltete Leistungsschalter, die beispielsweise in Brückenschaltungen zur Motoransteuerung verwendet werden. Dabei wird sowohl die durch den momentanen Schaltimpuls erzeugte Verlustwärme sowie die durch die vorhergehenden Schaltvorgänge akkumulierte Verlustwärme berücksichtigt. Der Überlastschutz ist auch für eine schlechte Wärmekopplung zwischen Leistungsschalter und Temperatursensor geeignet und außerdem für einen weiten Schwankungsbereich der Versorgungsspannung, da die Versorgungsspannung in die Berechnung der Verzögerungszeit zur Abschaltung eingeht. Durch die Trennung von Leistungs- und Steuerchip ist eine hohe Störsicherheit gegen Überstromspitzen gewährleistet. Da für die Herstellung der beiden Schaltkreise unterschiedliche, für deren jeweilige Funktion angepaßte Herstellungsprozesse zur Anwendung kommen, ergeben sich optimierte Herstellungskosten.

Nachfolgend wird die Erfindung anhand der in der Zeichnung dargestellten Ausführungsbeispiele näher erläutert. Es zeigen

Figur 1    ein Prinzipschaltbild des Leistungsschalters mit Überlastschutz,

Figur 2    eine schaltungstechnische Detailrealisierung des Überlastschutzes für einen kurzschlußfesten Leistungsschalter und

Figur 3    Signaldiagramme von in der Figur 2 vorkommenden Signalen.

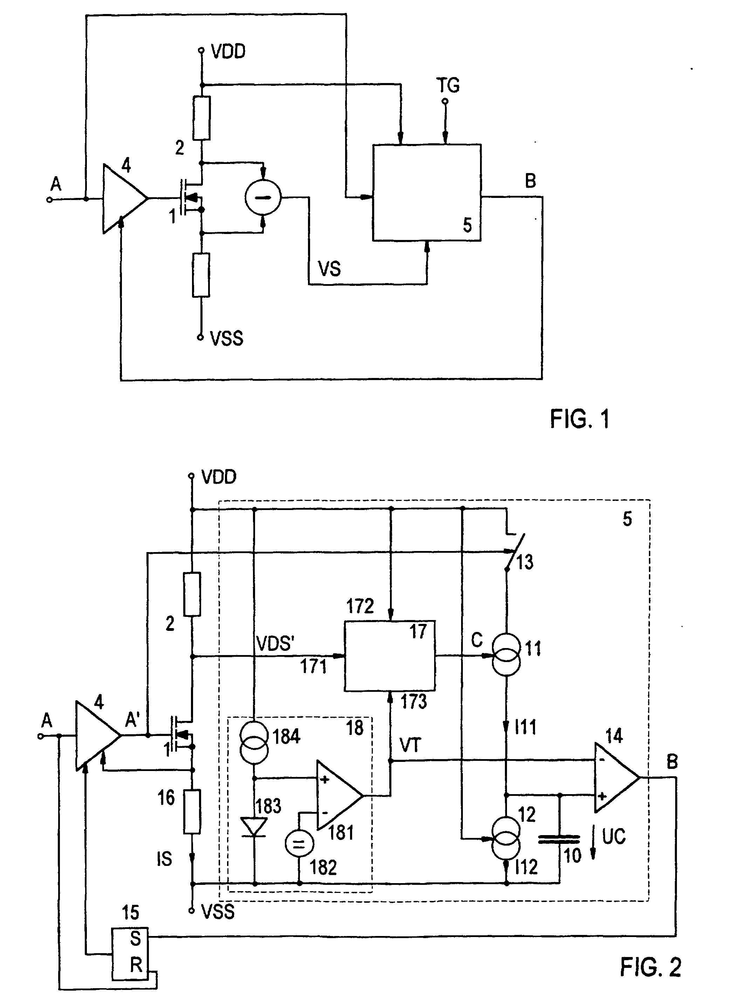

Die Leistungsschalteranordnung in Figur 1 zeigt als Leistungsschalter einen MOS-Feldeffekttansistor 1. Dieser ist in einen zwischen Anschlüsse für die Versorgungsspannung VDD, VSS geschalteten Strompfad geschaltet. In Reihe zum MOSFET 1 liegt eine Last 2. Durch ein Steuersignal A, das über einen Treiber 4 an den Gateanschluß des MOSFET 1 geführt ist, wird der MOSFET 1 ein- oder ausgeschaltet, wodurch die Last 2 an die Versorgungsspannung gelegt bzw. von ihr getrennt wird. Der MOSFET 1 ist ein n-Kanal-MOS-Transistor, dessen Sourceanschluß an das negative Versorgungspotential VSS gekoppelt ist, wobei die Last drainseitig liegt (Low-Side-Schalter). Die Erfindung ist auch anwendbar für einen High-Side-Schalter, dessen Drainanschluß an der positiven Versorgungsspannung VDD liegt und dessen Last sourceseitig an das negative Versorgungspotential angeschlossen ist.

Es ist eine Einrichtung 5 vorgesehen, durch die nach Feststellung von Überlast ein Abschaltsignal B erzeugt wird, welches den Treiber 4 blockiert und somit den Transistor 1 sofort abschaltet. Der Einrichtung 4 wird das Schaltsignal A zugeführt. Durch Abfrage weiterer Signale ermittelt die Einrichtung 5 eine Verzögerung, so daß die Einschaltflanke des Signals A dadurch verzögert als Signal B zum Abschalten ausgeben wird. Die Verzögerung tp wird berechnet aus der Versorgungsspannung VDD, der an der Drain-Source-Strecke des Schalttransistors abfallenden Spannung VS sowie einem Signal TG, das eine Temperatur angibt. Die Temperatur ist beispielsweise die Temperatur des integrierten Schaltkreises, in dem die Verzögerungseinrichtung 5 angeordnet ist. Nicht notwendigerweise müssen Leistungstransistor 1 und Verzögerungsschaltung 5 auf dem gleichen integrierten Schaltkreis angeordnet sein. Es genügt vielmehr, wenn der Schaltkreis der Verzögerungsschaltung 5 sowie der Transistor 1 auf getrennten Chips, aber mit ausreichender thermischer Kopplung zueinander angeordnet sind. In diesem Fall ist die Temperatur der Verzögerungsschaltung 5 näherungsweise gleich der Gehäusetemperatur des Transistors 1.

Die durch die Einrichtung 5 bewirkte Verzögerungszeit tp genügt der Beziehung

$$t_p \approx \frac{(Tj \max - TG)^2}{VDS \cdot VDD}$$

Es bedeuten

Tjmax:   maximal zulässige Sperrschichttemperatur des Leistungsschalters;
TG:   Temperatur des Verzögerungsschaltkreises 5;
VDS:   Drain-Source-Spannung des Leistungstransistors 1;
VDD:   auf Masse VSS bezogene Versorgungsspannung.

Die maximal mögliche Verzögerungszeit tp wird somit proportional zum Quadrat der Temperaturreserve, d. h. der Differenz aus maximaler Sperrschichttemperatur und momentaner Gehäusetemperatur, und umgekehrt proportional zur Drain-Source-Spannung des Leistungstransistors sowie der Versorgungsspannung eingestellt. Diese maximale Verzögerungszeit gilt idealerweise nur für einen einzigen Einschaltvorgang für den Leistungstransistor.

Bei periodischem Schalten des Leistungsschalters ist darüber hinaus die durch vorangegangene Einschaltzeiten akkumulierte Verlustwärme zu berücksichtigen. Die Verzögerungszeit, während der der Leistungsschalter in jeder Periode eingeschaltet bleiben kann, ohne zerstört zu werden, ist kürzer als der nach obiger Formel festgelegte Maximalwert. Die Verzögerungszeit zum überlastbedingten Abschalten für periodischen Schaltbetrieb des Transistors 1 ist derart zu bestimmen, daß das Tastverhältnis, d. h. das Verhältnis zwischen eingeschalteter Zeitdauer des Leistungsschalters geteilt durch die Schaltperiode, folgender Beziehung genügt:

$$D \approx \frac{Tj \max - TG}{VDS}$$

Das Tastverhältnis wird bei periodischem Schaltbetrieb so eingestellt, daß dann, wenn der Leistungsschalter bereits nach einem Bruchteil der maximalen Verzögerungszeit für einen Einzelimpuls multipliziert mit dem Kehrwert des maximalen Tastverhältnisses wieder eingeschaltet wird, die anschließende Verzögerungszeit ebenfalls nur diesen Bruchteil der maximalen Verzögerungszeit für den Einzelimpuls betragen darf. Während die Schaltperiode durch das den Leistungsschalter steuernde Signal A eingestellt wird, werden das Tastverhältnis und somit die Einschaltzeit (bzw. die Verzögerungszeit) durch die oben angegebene zuletzt genannte Formel angegeben.

Eine für eine Integration zweckmäßige Realisierung der Verzögerungsschaltung 5 ist in Figur 2 dargestellt. Diese enthält einen Kondensator 10, von dem ein Anschluß über eine erste Stromquelle 11 mit dem positiven Versorgungspotential VDD verbunden ist. Der eine Anschluß des Kondensators 10 ist über eine zweite Stromquelle 12 mit Masse VSS verbunden. Der andere Anschluß des Kondensators 10 ist direkt mit Masse verbunden. Über die Stromquelle 11 wird der Kondensator 10 aufgeladen, wenn der Leistungstransistor 1 eingeschaltet wird. Hierzu ist in den Strompfad der Stromquelle 11 ein Schalter 13 geschaltet, der parallel zum Leistungstransistor 1 mittels des Steuersignals A' am Ausgang des Treibers 4 gesteuert wird. Über die Stromquelle 12 wird der Kondensator 10 kontinuierlich entladen. Die Ladung des Kondensators 10 stellt ein Maß für die momentane Temperatur im Leistungsschalter 1 dar. Die Kondensatorspannung wird dem Plus-Eingang eines Komparators 14 zugeführt. Am Minus-Eingang des Komparators 14 liegt eine Vergleichsschwelle an, so daß dann, wenn die Kondensatorspannung den Vergleichswert überschreitet, das Abschaltsignal B erzeugt wird. Das Abschaltsignal B wird dem Setzeingang S eines Speicherelements 15 zugeführt, um die Ausschaltinformation zu halten. Der Ausgang des Flip-Flops 15 schaltet den Treiber 4 ab. Mit einem neuen Einschaltimpuls des Steuersignals A wird der Leistungstransistor 1 wieder eingeschaltet, indem der Einschaltimpuls A dem Rücksetzeingang des Flip-Flops 15 zugeführt wird, so daß der Treiber 4 wieder freigegeben wird. Im übrigen ist sourceseitig zum Leistungstransistor 1 ein niederohmiger Strombegrenzungswiderstand 16 geschaltet. Die am Widerstand 16 abfallende Spannung wird dem Treiber 4 mitgeteilt. Bei unzulässig hohem Stromanstieg fällt am Widerstand 16 eine derart erhöhte Spannung ab, daß der Treiber 4 ebenfalls blockiert wird oder der Treiber 4 die Gatespannung des Leistungstransistors 4 zumindest soweit vermindert, daß der über den Leistungstransistor fließende Strom über einen vorgegebenen Maximalstrom hinaus nicht ansteigt.

Der durch die (erste) gesteuerte Stromquelle 11 fließende Strom wird von einem Steuersignal C gesteuert, das durch eine Einrichtung 17 bereitgestellt wird. Die Einrichtung 17 ist ein Multiplizierer-Dividierer mit zwei Multipliziereingängen 171, 172 und einem dividierenden Eingang 173. Dem Eingang 171 wird die Drainspannung des Leistungstransistors 1 zugeführt. Da am niederohmigen Strombegrenzungswiderstand 16 eine relativ geringe Spannung abfällt, ist die Drainspannung des Leistungsschalters 1 nahezu gleich zu seiner Drain-Source-Spannung. Im Normalbetrieb bei ungestörter Last 2 fällt an der Last 2 eine derart hohe Spannung ab, daß die Drainspannung UDS' des Leistungstransistors 1 nahezu O V beträgt. Die im Transistor 1 entwickelte Verlustwärme ist gering und unkritisch. Bei Kurzschluß der Last 2 liegt am Transistor 1 nahezu die vollständige Versorgungsspannung VDD an. Die sich im Transistor 1 entwickelnde Verlustleistung ist dementsprechend hoch und kann zur Zerstörung führen. Die Drainspannung UDS' als charakteristische Spannung für den Leistungsschalter 1 wird daher dem Multiplizierer-Dividierer 17 als charakteristisches Signal für die Drain-Source-Spannung des Transistors 1 zugeführt. Außerdem wird dem Multiplizierer-Dividierer 17 am Anschluß 172 die auf Masse bezogene Versorgungsspannung VDD zugeführt. Insbesondere bei Anwendungen in der Kraftfahrzeugelektronik ist erforderlich, daß die Überlastabschaltung innerhalb eines weiten Versorgungsspannungsbereichs von 6 ... 40 Volt zuverlässig arbeitet. Daher erhält die Einrichtung 17 am Anschluß 172 die Versorgungsspannung VDD. Das Steuersignal C wird proportional zu den Eingangssignalen UDS' bzw. VDD verändert. Am Anschluß 173 wird ein Signal VT zugeführt, das die Temperaturreserve, d. h. die Differenz zwischen maximaler Sperrschichtspannung Tjmax und Gehäusetemperatur TG, angibt. Je geringer die Temperaturreserve ist, desto stärker ist die Stromquelle 11 auszusteuern. Das Signal C wird daher umgekehrt proportional zur Temperaturreserve VT gesteuert. Das Signal VT wird in einer Einrichtung 18 erzeugt, indem die Temperaturabhängigkeit der Sperrschichtspannung eines pn-Übergangs verwendet wird. Im einzelnen ist ein Differenzverstärker 181 vorgesehen, an dessen Minus-Eingang eine beispielsweise von einer Band-Gap-Spannungsquelle 182 temperaturstabil erzeugte Referenzspannung angelegt wird. Am Plus-Eingang wird die an einer Diode 183 gegenüber Masse abgreifbare Spannung eingespeist. Der Anodenanschluß der Diode 183 ist über eine Stromquelle 184 an die positive Versorgungsspannung VDD geschaltet. Die Diode ist relativ zum Leistungstransistor 1 derart anzuordnen, daß thermische Kopplung vorliegt. Die Sperrschichttemperatur der Diode ist dabei nahezu gleich der Gehäusetemperatur des Leistungstransistors.

Wie oben bereits ausgeführt, wird der Kondensator 10 durch die Stromquelle 11 aufgeladen, wobei deren Strom I11 in Abhängigkeit von der Drainspannung des Leistungstransistors 1, der Versorgungsspannung VDD und der Temperaturreserve VT gesteuert wird. Für das Entladen des Kondensators 10 über die Stromquelle 12 wird der von der Stromquelle 12 eingeprägte Strom I12 in Abhängigkeit von der Versorgungsspannung VDD gesteuert, indem der Steuereingang der Stromquelle 12 mit dem Anschluß für das Versorgungspotential VDD verbunden ist. Die Information über die Versorgungsspannung steht immer zur Steuerung für den Entladevorgang zur Verfügung. Die am Minus-Eingang des Komparators 14 angelegte Vergleichsschwelle ist das Signal VT für die Temperaturreserve.

Die Funktion der Gesamtschaltung zur Ermittlung der Verzögerungszeit $t_d$ für getakteten Schaltbetrieb des Leistungstransistors 1 ist im Detail folgende: Für den Aufladevorgang, durch den die Verzögerungszeit $t_d$ festgelegt wird gilt, bis der Komparator aktiviert wird:

$$t_d \approx UT \cdot \frac{1}{I11} = (Tj\max - TG) \cdot \frac{1}{\frac{VDS' \cdot VDD}{Tj\max - TG}}$$

Dabei ist berücksichtigt, daß der Strom I11 durch die Einrichtung 17 in Abhängigkeit von Temperaturreserve, Drainspannung und Versorgungsspannung eingestellt wird. Durch Vergleich mit der oben zuerst genannten Formel ergibt sich, daß der Aufladevorgang der maximalen Verzögerungszeit $t_d$ für ein einmaliges Einschalten entspricht. Ein periodisches Schalten des Leistungstransistors 1 wird durch die Stromquelle 12 nun dadurch berücksichtigt, daß das Verhältnis aus Entladestrom zu Ladestrom dem Tastverhältnis aus eingeschaltetem Zustand und Schaltperiode des Leistungsschalters 1 entspricht:

$$D \approx I12 \cdot \frac{1}{I11} \approx \frac{Tj\max - TG}{VDS' \cdot VDD} \cdot VDD$$

Das Verhalten der Schaltung entspricht somit der oben für das Tastverhältnis D genannten Beziehung. Die Spannung des Kondensators 10 wird durch das Verhältnis der von den gesteuerten Stromquellen 11, 12 eingeprägten Ströme bestimmt und im Komparator 14 mit der Temperaturreserve VT verglichen, um die Verzögerungszeit für das Ausschalten des Leistungsschalters 1 nach einem Einschaltimpuls zu bestimmen. Als Folge stellt sich ein Tastverhältnis ein, wie durch obige Formel angegeben. Dies gewährleistet, daß bei periodischem Schaltbetrieb eine Überlastung des Schalters bei Lastkurzschluß sicher verhindert wird. Dabei wird die aufgrund vorheriger Schaltvorgänge akkumulierte Verlustwärme berücksichtigt. Die Verzögerungsschaltung arbeitet über einen weiten Versorgungsspannungsbereich auch bei loser thermischer Kopplung zwischen Temperatursensor und Leistungsschalter zufriedenstellend.

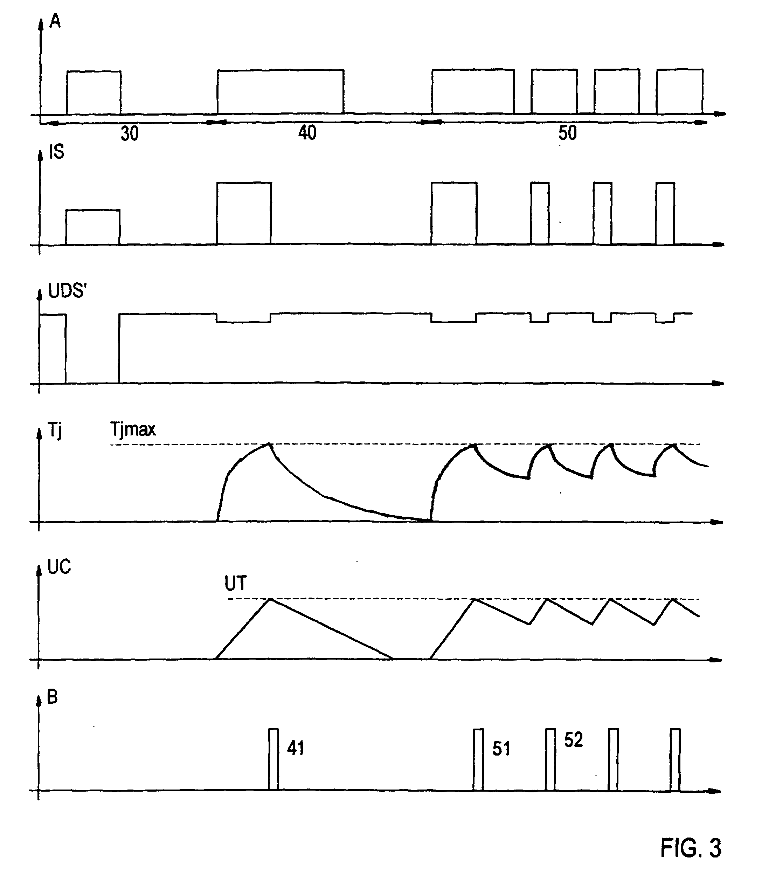

In Figur 3 sind das Schaltsignal A, der Transistorstrom IS, die Drainspannung UDS', die Sperrschichttemperatur Tj des Leistungsschalters, die Kondensatorspannung UC sowie der Ausschaltimpuls B dargestellt. Der Zeitabschnitt 30 zeigt den Normalbetrieb mit ungestörter Last 2. Der Spannungsabfall längs der Last 2 sorgt dafür, daß am Schalter 1 während der Einschaltphase nahezu keine Spannung abfällt. Die Temperatur des Leistungsschalters wird nicht erhöht. Der Zeitabschnitt 40 stellt einen einmaligen Einschaltvorgang bei Lastkurzschluß dar. Längs des Transistors 1 fällt während des Einschaltzustands nahezu die volle Versorgungsspannung ab. Die Temperatur Tj der Sperrschichten im Leistungstransistor steigt an. In entsprechender Weise steigt die Kondensatorspannung UC. Beim Erreichen der Temperaturreserve VT erfolgt ein Abschaltimpuls 41. Im Zeitabschnitt 50 ist der periodische Betrieb dargestellt. Beim ersten Einschaltimpuls steigt die Sperrschichttemperatur Tj an, bis die Kondensatorspannung $U_C$ den Vergleichswert VT der Temperaturreserve erreicht. Es erfolgt ein Abschaltimpuls 51. Die Sperrschichttemperatur Tj fällt ab, in entsprechender Weise fällt die Kondensatorspannung UC, indem der Kondensator 10 durch die Stromquelle 12 entladen wird. Durch einen weiteren Einschaltimpuls des Steuersignals A wird der Transistor 1 wieder eingeschaltet. Die Sperrschichttemperatur Tj steigt wiederum an, und der noch nicht vollständig entladene Kondensator 10 wird über die Stromquelle 11 weiter aufgeladen, bis der Komparator 14 wieder aktiviert wird und einen Abschaltimpuls 52 erzeugt. Dieser Vorgang wird periodisch fortgesetzt.

**Patentansprüche**

1.  Leistungsschalter mit Überlastschutz, umfassend:

    -   den Leistungsschalter (1), der in einem zwischen Anschlüssen für eine Versorgungsspannung (VDD, VSS) geschalteten Strompfad geschaltet ist und der in Abhängigkeit von einem Steuersignal (A, A') in einen eingeschalteten und einen ausgeschalteten Zustand schaltbar ist,
    -   ein Verzögerungselement (5), dem das Steuersignal (A') zugeführt wird und durch das ein Abschaltsignal (B) nach einer Verzögerungszeit erzeugt wird, um den Leistungsschalter (1) abzuschalten,
    -   wobei das Verzögerungselement (5) Mittel aufweist, durch die die Verzögerungszeit in Abhängigkeit von einer längs des Leistungsschalters (1) abfallenden Spannung (VS, VDS'), von der Versorgungsspannung (VDD) und von einem Temperatursignal (VT), das die Differenz zwischen einem Referenzwert (182) und der Temperatur eines an den Leisstungsschalter (1) thermisch gekoppelten Temperaturelement (183) angibt, gebildet wird, wobei durch die Mittel die Verzögerungszeit derart gebildet wird, dass sie unter der Annahme einer konstanten Versorgungsspannung (VDD) und eines konstanten Temperatursignals (VT) wenigstens annäherungsweise umgekehrt proportional der am Leistungsschalter (1) abfallenden Spannung (VDS') ist.

2.  Leistungsschalter nach Anspruch 1,
    **dadurch gekennzeichnet, daß**
    durch die Mittel die Verzögerungszeit derart gebildet wird, dass sie unter der Annahme einer konstanten am Leistungsschalter (1) abfallenden Spannung (VDS') und einer konstanten Versorgungsspannung (VDD) wenigstens annäherungsweise proportional dem Quadrat des Temperatursignals (VT) ist.

3.  Leistungsschalter nach Anspruch 2,
    **dadurch gekennzeichnet, daß**
    durch die Mittel die Verzögerungszeit derart gebildet wird, dass sie unter der Annahme einer konstanten am Leistungsschalter (1) abfallenden Spannung (VDS') und eines konstanten Temperatursignals (VT) wenigstens annäherungsweise umgekehrt proportional der Versorgungsspannung (VDD) ist.

4.  Leistungsschalter nach einem der Ansprüche 1 bis 3,
    **dadurch gekennzeichnet, daß**
    das Steuersignal (A, A') ein periodisches Taktsignal ist, und daß durch die Mittel die Verzögerungszeit geringer als derjenige Wert gebildet wird, der sich proportional dem Quadrat des Temperatursignals (VT) und umgekehrt proportional der am Leistungsschalter (1) abfallenden Spannung (VDS) und umgekehrt proportional der Versorgungsspannung (VDD) ergibt.

5.  Leistungsschalter nach einem der Ansprüche 1 bis 4,
    **dadurch gekennzeichnet, daß**
    durch die Mittel die Verzögerungszeit derart eingestellt wird, daß das Verhältnis von eingeschalteter Zeitdauer des Leistungsschalters (1) geteilt durch die Schaltperiode maximal einem Wert ist, der proportional dem Temperatursignal (VT) geteilt durch die am Leistungsschalter (1) abfallende Spannung (VDS') ist.

**6.** Leistungsschalter nach einem der Ansprüche 1 bis 5,
**dadurch gekennzeichnet, daß**
daß ein Kondensator (10) vorgesehen ist mit einem Anschluß, der über eine erste steuerbare Stromquelle (11) mit dem Anschluß für ein erstes Versorgungspotential (VDD) verbunden ist, daß die erste Stromquelle (11) proportional zu der am Leistungsschalter (1) abfallenden Spannung (VDS'), proportional zur Versorgungsspannung (VDD) und umgekehrt proportional zum Temperatursignal (VT) gesteuert wird, daß der Anschluß des Kondensators (10) über eine zweite Stromquelle (12) mit einem Anschluß für ein anderes Versorgungspotential (VSS) verbunden ist, daß ein Komparator (14) vorgesehen ist, durch den die am Kondensator (10) anliegende Spannung mit einem vorgegebenen Vergleichswert (VT) verglichen wird, und daß durch ein Ausgangssignal (B) des Komparators (14) der Leistungsschalter (1) abgeschaltet wird.

**7.** Leistungsschalter nach Anspruch 6,
**dadurch gekennzeichnet, daß**
die zweite Stromquelle (12) eine steuerbare Stromquelle ist, die abhängig von der Versorgungsspannung (VDD) steuerbar ist.

**8.** Leistungsschalter nach einem der Ansprüche 6 oder 7,
**dadurch gekennzeichnet, daß**
der Vergleichswert des Komparators (14) durch das Temperatursignal (VT) gebildet ist.

**9.** Leistungsschalter nach einem der Ansprüche 6 bis 8
**dadurch gekennzeichnet, daß**
eine Einrichtung (17) zur Mulitplikation und Division vorgesehen ist, durch die ein Steuersignal (C) zur Steuerung der ersten Stromquelle (11) dadurch ermittelt wird, daß die Versorgungsspannung (VDD) mit der Drainspannung (VDS') des als Transistor ausgeführten Leistungsschalters (11) multipliziert wird und durch das Temperatursignal (VT) dividiert wird.

**10.** Leistungsschalter nach einem der Ansprüche 6 bis 9,
**gekennzeichnet durch**
einen Schalter (13) im Strompfad der ersten steuerbaren Stromquelle (11), der vom den Leistungsschalter (1) schaltenden Steuersignal (A') gesteuert wird.

**11.** Leistungsschalter nach einem der vorangehenden Ansprüche,
**dadurch gekennzeichnet, daß**
die Verzögerungszeit folgender Beziehung genügt:

$$t_p \approx \frac{(Tj\text{max-}TG)^2}{VDS \cdot VDD}$$

wobei

$t_p$      die Verzögerungszeit,
Tjmax      die maximal zulässige Sperrschichttemperatur des Leistungsschalter,
TG      die Temperatur des Verzögerungselements,
VDS      die über dem Leistungsschalter abfallende Spannung,
VDD      die Versorgungsspannung

ist.

**Claims**

**1.** Circuit breaker with overload protection, comprising:

- the circuit breaker (1), which is connected in a current path connected between connections for a supply voltage (VDD, VSS) and can be switched to a connected state and to a disconnected state as a function of a control signal (A, A'),

- a delay element (5) to which the control signal (A') is supplied and by means of which a disconnection signal (B) is produced after a delay time, in order to disconnect the circuit breaker (1),
- in which case the delay element (5) has means by which the delay time is formed as a function of a voltage (VS, VDS') which is dropped across the circuit breaker (1), of the supply voltage (VDD) and of a temperature signal (VT) which indicates the difference between a reference value (182) and the temperature of a temperature element (183) which is thermally coupled to the circuit breaker (1), with the delay time being formed by the means such that, on the assumption that the supply voltage (VDD) is constant and that a temperature signal (VT) is constant, it is at least approximately inversely proportional to the voltage (VDS') which is dropped across the circuit breaker (1).

2. Circuit breaker according to Claim 1,
   **characterized in that**
   the delay time is formed by the means such that, on the assumption that the voltage (VDS') which is dropped across the circuit breaker (1) is constant and that the supply voltage (VDD) is constant, it is at least approximately proportional to the square of the temperature signal (VT).

3. Circuit breaker according to Claim 2,
   **characterized in that**
   the delay time is formed by the means such that, on the assumption that the voltage (VDS') which is dropped across the circuit breaker (1) is constant and that the temperature signal (VT) is constant, it is at least approximately inversely proportional to the supply voltage (VDD).

4. Circuit breaker according to one of Claims 1 to 3,
   **characterized in that**
   the control signal (A, A') is a periodic clock signal, and **in that** the means form the delay time to be less than that value which results in proportion to the square of the temperature signal (VT), in inverse proportion to the voltage (VDS) which is dropped across the circuit breaker (1), and in inverse proportion to the supply voltage (VDD).

5. Circuit breaker according to one of Claims 1 to 4,
   **characterized in that**
   the means set the delay time in such a manner that the ratio of the connected time duration of the circuit breaker (1) divided by the switching period does not exceed a value which is proportional to the temperature signal (VT) divided by the voltage (VDS') which is dropped across the circuit breaker (1).

6. Circuit breaker according to one of Claims 1 to 5,
   **characterized in that**
   a capacitor (10) is provided, having a connection which is connected via a first controllable current source (11) to the connection for a first supply potential (VDD), **in that** the first current source (11) is controlled in proportion to the voltage (VDS') which is dropped across the circuit breaker (1), in proportion to the supply voltage (VDD) and in inverse proportion to the temperature signal (VT), **in that** the connection of the capacitor (10) is connected via a second current source (12) to a connection for another supply potential (VSS), **in that** a comparator (14) is provided, by means of which the voltage which is present across the capacitor (10) is compared with a predetermined comparison value (VT), and **in that** the circuit breaker (1) is disconnected by an output signal (B) from the comparator (14).

7. Circuit breaker according to Claim 6,
   **characterized in that**
   the second current source (12) is a controllable current source which can be controlled as a function of the supply voltage (VDD).

8. Circuit breaker according to one of Claims 6 or 7,
   **characterized in that**
   the comparison value of the comparator (14) is formed by the temperature signal (VT).

9. Circuit breaker according to one of Claims 6 to 8,
   **characterized in that**
   a device (17) is provided for multiplication and division, by means of which a control signal (C) for controlling the first current source (11) is determined **in that** the supply voltage (VDD) is multiplied by the drain voltage (VDS') of the circuit breaker (1) (which is configured as a transistor) and is divided by the temperature signal (VT).

**10.** Circuit breaker according to one of Claims 6 to 9,
**characterized by**
a switch (13) in the current path of the first controllable current source (11), which switch (13) is controlled by the control signal (A') which switches the circuit breaker (1).

**11.** Circuit breaker according to one of the preceding claims, **characterized in that** the delay time satisfies the following relationship:

$$t_p \approx \frac{(Tjmax\text{-}TG)^2}{VDS \cdot VDD}$$

where

$t_p$     is the delay time,
Tjmax    is the maximum permissible depletion layer temperature of the circuit breaker,
TG       is the temperature of the delay element,
VDS      is the voltage dropped across the circuit breaker,
VDD      is the supply voltage.

**Revendications**

**1.** Commutateur de puissance avec protection contre les surcharges comprenant :

- le commutateur de puissance (1) qui est commuté dans un trajet de courant commuté entre des connexions pour une tension d'alimentation (VDD, VSS) et qui peut être commuté en un état allumé ou éteint en fonction d'un signal de commande (A, A'),
- un élément de retard (5) auquel est amené le signal de commande (A') et qui permet de générer un signal de coupure (B) afin de couper le commutateur de puissance (1)
- l'élément de retard (5) présentant des moyens permettant de former le temps de retard en fonction d'une tension (VS, VDS') sur le commutateur de puissance (1), de la tension d'alimentation (VDD) et d'un signal de température (VT) qui indique la différence entre une valeur de référence (182) et la température d'un élément thermosensible (183) couplé thermiquement au commutateur de puissance (1), le temps de retard étant formé par les moyens pour être au moins approximativement inversement proportionnel à la tension (VDS') sur le commutateur de puissance (1) en supposant la présence d'une tension d'alimentation constante (VDD) et d'un signal de température constant (VT).

**2.** Commutateur de puissance selon la revendication 1,
**caractérisé en ce que**
le temps de retard est formé par les moyens pour être au moins approximativement proportionnel au carré du signal de température (VT) en supposant une tension constante (VDS') sur le commutateur de puissance (1) et une tension d'alimentation constante (VDD).

**3.** Commutateur de puissance selon la revendication 2,
**caractérisé en ce que**
le temps de retard est formé par les moyens pour être au moins approximativement inversement proportionnel à la tension d'alimentation (VDD) en supposant une tension constante (VDS') sur le commutateur de puissance (1) et un signal de température constant (VT).

**4.** Commutateur de puissance selon l'une quelconque des revendications 1 à 3,
**caractérisé en ce que**
le signal de commande (A, A') est un signal de synchronisation périodique et le temps de retard est formé par les moyens de manière à être inférieur à la valeur proportionnelle au carré du signal de température (VT), et inversement proportionnelle à la tension (VDS) sur le commutateur de puissance (1) et inversement proportionnelle à la tension d'alimentation (VDD).

**5.** Commutateur de puissance selon l'une quelconque des revendications 1 à 4,
**caractérisé en ce que**
les moyens permettent de régler le temps de retard de manière à ce que le rapport de la durée activée du commutateur de puissance (1) divisé par la période de commutation soit au maximum proportionnel au signal de température (VT) divisé par 1a tension (VDS') sur le commutateur de puissance (1).

**6.** Commutateur de puissance selon l'une quelconque des revendications 1 à 5,
**caractérisé en ce qu'**
un condensateur (10) est prévu avec une connexion reliée à la connexion pour un premier potentiel d'alimentation (VDD) via une première source de courant réglable (11), la première source de courant (11) étant réglée proportionnellement à la tension (VDS') sur le commutateur de puissance (1), proportionnellement à la tension d'alimentation (VDD) et inversement proportionnellement au signal de température (VT), la connexion du condensateur (10) étant reliée à une connexion pour un autre potentiel d'alimentation (VSS) via une deuxième source de courant (12), et est prévu un comparateur (14) permettant de comparer la tension du condensateur (10) à une valeur de comparaison (VT) donnée et le commutateur de puissance (1) est coupé par un signal de sortie (B) du comparateur (14).

**7.** Commutateur de puissance selon la revendication 6,
**caractérisé en ce que**
la deuxième source de courant (12) est une source de courant réglable en fonction de la tension d'alimentation (VDD).

**8.** Commutateur de puissance selon l'une quelconque des revendications 6 ou 7,
**caractérisé en ce que**
la valeur de comparaison du comparateur (14) est formée par le signal de température (VT).

**9.** Commutateur de puissance selon l'une quelconque des revendications 6 à 8,
**caractérisé par**
un dispositif (17) de multiplication et de division déterminant un signal de commande (C) pour la première source de courant (11), la tension d'alimentation (VDD) étant multipliée par la tension du drain (VDS') du commutateur de puissance (1) formé par un transistor et divisée par le signal de température (VT).

**10.** Commutateur de puissance selon l'une quelconque des revendications 6 à 9,
**caractérisé par**
un commutateur (13), dans le trajet de courant de la première source de courant (11) réglable, commandé par le signal de commande (A') commandant le commutateur de puissance (1).

**11.** Commutateur de puissance selon l'une quelconque des revendications précédentes,
**caractérisé en ce que** le temps de retard correspond au rapport suivant :

$$t_p \approx \frac{(Tj\text{max-}TG)^2}{VDS \cdot VDD}$$

$t_p$      temps de retard,
Tjmax     température maximum autorisée de la couche diélectrique du commutateur de puissance,
TG      température de l'élément de retard,
VDS     tension sur le commutateur de puissance et
VDD     tension d'alimentation.

FIG. 1

FIG. 2

FIG. 3